# EUROPÄISCHE PATENTANMELDUNG

(11) **EP 1 750 135 A1**
(43) Veröffentlichungstag der Anmeldung: **07.02.2007**
(21) Anmeldenummer: 06116946.2
(22) Anmeldetag: 11.07.2006
(51) Int. Cl.: G01R 1/067

(54) **Testkopf mit Drucksensor**

(30) Priorität: 04.08.2005 DE 102005036856
(71) Anmelder: Rohde & Schwarz GmbH & Co. KG, 81671 München (DE)
(72) Erfinder: Reich, Friedrich, 86391, Stadtberg (DE); Peschke, Martin, 81739, München (DE)
(74) Vertreter: Körfer, Thomas

(57) **Zusammenfassung**

Die Erfindung betrifft einen Tastkopf (1) mit einer Tastkopfspitze (2), wobei der Tastkopf (1) über eine Schnittstelle (8) an ein elektronisches Messgerät (9) anschließbar ist. An der Tastkopfspitze (2) des erfindungsgemäßen Tastkopfs (1) ist ein Drucksensor (6) vorhanden, der einen Anpressdruck auf die Tastkopfspitze (2) erfasst und bei einem Überschreiten eines festgelegten Anpressdrucks eine bestimmte Funktionalität des angeschlossenen Messgeräts (9) auslöst.

## Beschreibung

Die vorliegende Erfindung bezieht sich auf einen Tastkopf mit einem Drucksensor für ein Messgerät, insbesondere ein Oszilloskop.

Aus der US 2004/0239309 A1 ist ein Tastkopf bekannt, der an seinem Griff verschiedene Bedienelemente aufweist. Dieser Tastkopf ist an ein Oszilloskop angeschlossen, wobei die am Tastkopf angebrachten Bedienelemente Bedienfunktionen des Oszilloskops entsprechen. Nachteilig an diesem Tastkopf ist, dass Funktionen am angeschlossenen Oszilloskop erst aktiviert werden können, wenn der Tastkopf die zu untersuchende Leiterbahn kontaktiert. Dadurch, dass die am Griff angebrachten Bedienelemente mechanisch zu betätigen sind, kann der Tastkopf sich auf Grund von mechanischen Kräften, die bei der Betätigung der Bedienelemente am Griff auf den Tastkopf wirken, verschieben. Dadurch kann es dazu kommen, dass das gemessene Signal nicht dem vorgesehenen zu messenden Signal entspricht, da der Tastkopf sich auf eine benachbarte Leiterbahn verschoben hat.

Der Erfindung liegt daher die Aufgabe zu Grunde, einen Tastkopf mit Bedienelementen zur Fernbedienung eines angeschlossenen Messgeräts zu schaffen, der während der Betätigung der Bedienelemente stabil in der Messposition bleibt.

Diese Aufgabe wird erfindungsgemäß durch den in Anspruch 1 beschriebenen Tastkopf gelöst. Vorteilhafte Weiterbildungen der Erfindung sind in den Unteransprüchen angegeben.

Ein Vorteil des erfindungsgemäßen Tastkopfs liegt darin, dass dieser über eine Schnittstelle an ein elektronisches Messgerät anschließbar ist, so dass das Messgerät über den Tastkopf fernbedienbar wird. An der Tastkopfspitze ist ein Drucksensor angebracht ist, der einen Anpressdruck auf die Tastkopfspitze erfasst und bei einem Überschreiten eines festgelegten Anpressdrucks eine bestimmte Funktionalität des Messgeräts, wie z.B. den Start oder das Stoppen einer Messung auslöst. Dadurch, dass eine Funktionalität durch Ansetzen und Andrücken des erfindungsgemäßen Tastkopfs ausgelöst wird, ist gewährleistet, dass die durch das Ansetzen des Tastkopfes festgelegte Messposition sich während der manuelle Bedienung des Tastkopfes nicht ändert.

Ein weiterer Vorteil einer Weiterbildung des erfindungsgemäßen Tastkopfes ist, dass zusätzlich zum Drucksensor in der Tastkopfspitze noch ein betätigungsloses Bedienelement am Griff des Tastkopfes angebracht sein kann. Dadurch kann beispielsweise ein Laden von im angeschlossenen Messgerät gespeicherten Parametern aktiviert werden.

Weiter ist es von Vorteil, dass bei einer weiteren Weiterbildung des erfindungsgemäßen Tastkopfs der an der Tastkopfspitze angebrachte Drucksensor mit einem mechanischen Bedienelement am Tastkopf kombinierbar ist. Dadurch ist es dem Benutzer möglich, alle am angeschlossenen Messgerät vorhandenen Funktionalitäten über den erfindungsgemäßen Tastkopf zu aktivieren.

Ein weiterer Vorteil des erfindungsgemäßen Tastkopfs besteht darin, dass der Benutzer die Funktionalität der Bedienelemente gemäß seinen Erfordernissen festlegen kann.

Ein Ausführungsbeispiel der Erfindung wird nachfolgend unter Bezugnahme auf die Zeichnung näher beschrieben. In der Zeichnung zeigt:

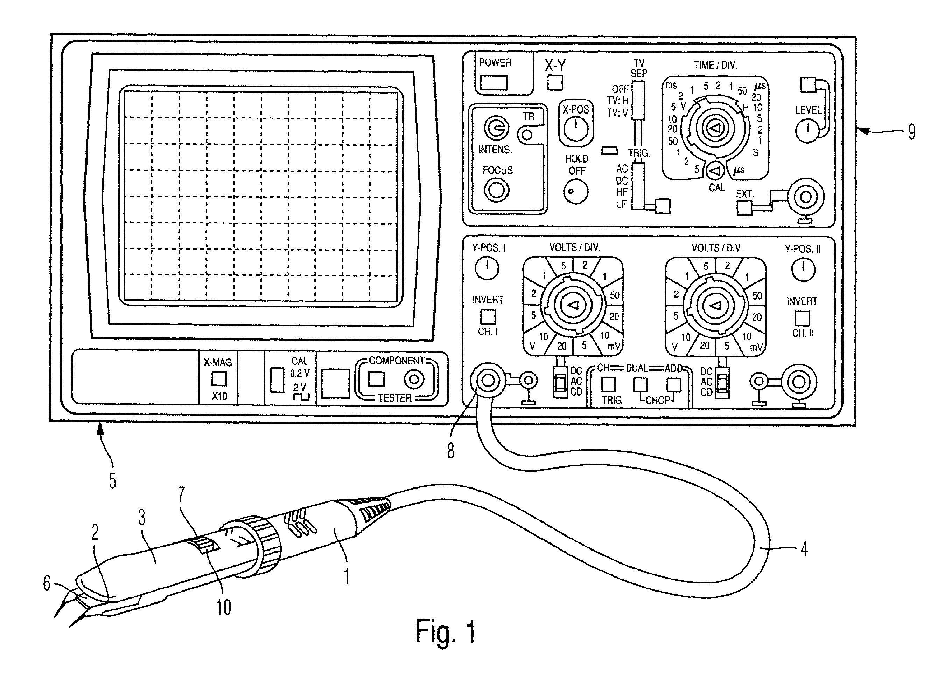

- Fig. 1: einen erfindungsgemäßen Tastkopf, der an ein Oszilloskop angeschlossen ist.

Fig. 1 zeigt ein Ausführungsbeispiel eines erfindungsgemäßen Tastkopfs 1, der an ein Oszilloskop 5 angeschlossen ist. Der erfindungsgemäße Tastkopf 1 weist eine Tastkopfspitze 2 auf und ist über eine Schnittstelle 8 eines elektronischen Messgerätes 9, wie z.B. eines Oszilloskops 5, angeschlossen. Der erfindungsgemäße Tastkopf 1 kann über ein Kabel 4 oder über eine drahtlose Schnittstelle an das elektronische Messgerät 9 angeschlossen sein. In dem Kabel 4 ist ein Gerätebus oder eine zusätzliche Steuerleitung vorhanden. An der Tastkopfspitze 2 befindet sich ein Drucksensor 6, der einen Anpressdruck auf die Tastkopfspitze 2 erfasst und bei einem Überschreiten eines festgelegten Anpressdrucks eine bestimmte Funktionalität am angeschlossenen Messgerät 9 auslöst.

Beim Aufsetzen der Tastkopfspitze 2 auf eine elektrische Leitung wird z.B. eine Messung an dem angeschlossenen Messgerät 9 aktiviert, sobald der momentan anliegende und vom Drucksensor 6 erfasste Anpressdruck einen festgelegten Anpressdruck überschreitet. Eine Reduzierung oder eine weitere Steigerung des Anpressdrucks, der mit der Tastkopfspitze 2 auf eine elektrische Leitung ausgeübt wird, bewirkt z.B. ein Abschalten (Stoppen) der gerade laufenden Messung. Eine derartige Toggelfunktion ist z.B. auch für andere, am angeschlossenen Messgerät 9 implementierte Funktionalitäten, wie z.B. eine Autoskalierungsfunktion denkbar.

Zusätzlich zum Drucksensor 6 an der Tastkopfspitze 2 kann bei einem bevorzugten Ausführungsbeispiel des erfindungsgemäßen Tastkopfes 1 ein Bedienelement 7 an einem Griff 3 des Tastkopfes 1 angebracht sein. Dieses vorzugsweise nicht mechanische Bedienelement kann eine fest vorgegebene Funktionalität aufweisen, was bedeutet, dass diese Funktionalität vom Benutzer des Tastkopfes 1 nicht umkonfiguriert werden kann, sondern bereits bei der Fertigung des erfindungsgemäßen Tastkopfes 1 in seinen Funktionsumfang integriert ist. Ein mögliches Bedienelement, das keine mechanische Betätigung erfordert, ist ein Leitfähigkeitssensor, der bei manuellem Berühren des Bedienelements durch einen Finger der Bedienperson die Leitfähigkeit erfasst. Überschreitet die erfasste Leitfähigkeit einen festgelegten Wert, so wird im an den erfindungsgemäßen Tastkopf 1 angeschlossenen Messgerät 9 eine Funktionalität aktiviert. Diese Funktionalität kann z.B. ein Neustart einer Messung, eine Speicherung einer Messung, ein Aufruf von im Messgerät gespeicherten Skalierungsparametern (y/Div), die Auswahl einer bestimmten Zeitbasis (x/Div) oder die Auswahl einer bestimmten Triggerfunktion oder eines Triggeroffset sein.

Bei einem weiteren Ausführungsbeispiel des erfindungsgemäßen Tastkopfes 1 ist das betätigungslose Bedienelement als Wärmesensor ausgeführt, der bei manuellem Berühren des Bedienelements eines Fingers der Bedienperson die Temperatur erfasst und bei einem Überschreiten einer festgelegten Temperatur eine Funktionalität im an den erfindungsgemäßen Tastkopf 1 angeschlossenen Messgerät 9 auslöst. Diese Funktionalität kann auch hier z.B. ein Neustart einer Messung, eine Speicherung einer Messung, ein Aufruf von im Messgerät gespeicherten Skalierungsparametern (y/Div), die Auswahl einer bestimmten Zeitbasis (x/Div) oder die Auswahl einer bestimmten Triggerfunktion oder eines Triggeroffset sein.

Ein weiteres Ausführungsbeispiel des erfindungsgemäßen Tastkopfes 1 geht davon aus, dass statt einem betätigungslosen Bedienelement ein mechanisches Bedienelement 7, wie zum Beispiel ein Druckknopf, ein Drehrad oder ein Wippschalter 10 am Griff 3 des erfindungsgemäßen Tastkopfes 1 angebracht ist.

Das Drehrad könnte dann beispielsweise auf das soeben aktive Eingabefeld am Messgerät 9, z.B. dem Oszilloskop, arbeiten, so dass eine explizite Programmierung des Focus entfallen könnte. Ein zusätzlicher Knopf oder eine Druckempfindlichkeit des Drehrades könnte innerhalb eines Eingabedialoges die Focusweiterschaltung übernehmen, so dass letztendlich viele verschiedene Werte innerhalb eines Dialoges verändert werden könnten, ohne dass der Anwender den Tastkopf vom Messobjekt abnehmen muss, um das Oszilloskop mit der Hand zu bedienen.

Der Druckknopf oder das Drehrad bzw. der Wippschalter 10 ist besonders bevorzugt individuell mit einer am angeschlossenen Messgerät 9 vorhandenen Funktionalität konfigurierbar.

Auch eine Kombination von mechanischen Bedienelementen 7 wie zum Beispiel ein Druckknopf und ein Drehrad oder ein Wippschalter 10 am Griff 3 des erfindungsgemäßen Tastkopfes 1 ist realisierbar, so dass z.B. mittels des erfindungsgemäßen Tastkopfes 1 durch Steigerung des Anpressdrucks die Messung am angeschlossenen Messgerät 9 gestartet wird und durch das Betätigen des Druckknopfes eine automatische Skalierung aktiviert wird. Mittels des Drehrads kann z.B. die Triggerschwelle variiert werden oder mittels des Wippschalters 10 kann zwischen zwei individuell festlegbaren Zeitskalen umgeschaltet werden, so dass eine für den Benutzer vorteilhafte Darstellung des Messsignals gewährleistet ist.

Die Kommunikation zwischen Tastkopf 1 und Messgerät 9 kann über eine beliebige Schnittstelle 8 erfolgen. Dies kann beispielsweise ein serieller Gerätebus oder eine zusätzliche Steuerleitung je Knopf sein, die über die Probe-Anschlussbox zum Messgerät 9 geführt wird. Ein Knopf liefert bei Betätigung z.B. einen Impuls. Es ist auch denkbar, dass die Länge des Pulses ausgewertet wird, um z.B. einen Wert zu erhöhen (langer Puls = langes Drücken) oder zu erniedrigen (kurzer Puls). Denkbar ist auch, dass der erste Impuls die Messung startet, der zweite Druck sie wieder stoppt. Allgemein ist so eine Toggelfunktion für beliebige 1 aus n-Einstellungen möglich.

Die Bedienelemente befinden sich vorzugsweise im vorderen Teil des Tastkopfes 1, knapp vor der Stelle, an der der Tastkopf üblicherweise mit den Fingerspitzen der Bedienperson gehalten wird. Druckschalter müssen vorzugsweise einen Druckpunkt haben, der es ermöglicht, den Knopf ohne großen Kraftaufwand zu betätigen. Ist der Druckpunkt zu stark, so wird der Anwender die Kontaktposition des Tastkopfes leicht verschieben und damit eine Fehlmessung hervorrufen. Ist der Druckpunkt zu schwach, so kann der Anwender versehentlich eine Aktion auslösen. Der Drucksensor kann entweder an der elektrischen Tastkopfspitze angeordnet sein und den Anpressdruck messen, der auf die elektrische Tastkopfspitze ausgeübt wird, über welche das elektrische Signal in den Tastkopf eingekoppelt wird. Alternativ ist es auch denkbar, dass der Tastkopf zwei Tastkopfspitzen hat. Eine Tastkopfspitze dient dann zur Einkopplung des elektrischen Messsignals. Die andere Tastkopfspitze liegt auf dem Prüfling ebenfalls auf und besteht vorzugsweise aus einem elektrisch nicht leitenden Material, beispielsweise einem Kunststoffmaterial. Die zweite Tastkopfspitze dient dann lediglich zur Erfassung des Anpressdrucks, mit welchem der Tastkopf gegen den Prüfling gedrückt wird. Der Drucksensor steht dann nur mit diesem zweiten elektrisch isolierenden Tastkopf in Verbindung. Der Vorteil liegt dann insbesondere darin, dass die Anordnung des Drucksensors die hochfrequenztechnische Konfiguration der elektrischen Tastkopfspitze nicht negativ beeinflusst.

Die Erfindung ist nicht auf das dargestellte Ausführungsbeispiel bzw. die beschriebenen Ausführungsbeispiele beschränkt und kann z.B. sowohl an ein Oszilloskop, einen Signalgenerator oder an einen Netzwerkanalysator angeschlossen werden.

Als Drucksensor kann vorteilhaft ein Piezo-Element verwendet werden. Die bestimmte Funktionalität, die durch den Drucksensor ausgelöst wird, ist vorteilhaft eine von der Bedienperson konfigurierbare Funktionalität.

## Patentansprüche

1. Tastkopf (1) mit einer Tastkopfspitze (2), wobei der Tastkopf (1) über eine Schnittstelle (8) an ein elektronisches Messgerät (9) anschließbar ist und an der Tastkopfspitze (2) ein Drucksensor (6) vorhanden ist, der einen Anpressdruck auf die Tastkopfspitze (2) erfasst und bei einem Überschreiten eines festgelegten Anpressdrucks eine bestimmte Funktionalität des angeschlossenen Messgeräts (9) auslöst.

2. Tastkopf nach Anspruch 1,
**dadurch gekennzeichnet,**
**dass** beim Aufsetzen der Tastkopfspitze (2) auf eine elektrische Leitung eine Messung an dem angeschlossenen Messgerät (9) aktiviert oder gestoppt wird, wenn der momentane Anpressdruck den festgelegten Anpressdruck überschreitet.

3. Tastkopf nach Anspruch 1 oder 2,
**dadurch gekennzeichnet,**
**dass** ein Bedienelement (7) mit festgelegter Funktionalität an einem Griff (3) des Tastkopfes (1) angebracht ist.

4. Tastkopf nach Anspruch 3,
**dadurch gekennzeichnet,**
**dass** das Bedienelement (7) einen Leitfähigkeitssensor aufweist, der bei einem Überschreiten einer festgelegten Leitfähigkeit eine bestimmte Funktionalität im angeschlossenen Messgerät (9) aktiviert.

5. Tastkopf nach Anspruch 4,
**dadurch gekennzeichnet,**
**dass** der Leitfähigkeitssensor bei manuellem Berühren des Bedienelements die Leitfähigkeit eines Fingers der Bedienperson erfasst.

6. Tastkopf nach Anspruch 3,
**dadurch gekennzeichnet**,
das Bedienelement einen Wärmesensor aufweist, der bei einem Überschreiten einer festgelegten Temperatur eine Funktionalität im angeschlossenen Messgerät (9) aktiviert.

7. Tastkopf nach Anspruch 6,
**dadurch gekennzeichnet,**
**dass** der Wärmesensor bei manuellem Berühren des Bedienelements die Temperatur eines Fingers der Bedienperson erfasst.

8. Tastkopf nach einem der Ansprüche 1 bis 7,
**dadurch gekennzeichnet,**
**dass** ein Bedienelement (7) mit programmierbarer Funktionalität am Griff (3) des Tastkopfes (1) angebracht ist, wobei dieses Bedienelement (7) zumindest einen Druckknopf, ein Drehrad oder einen Wippschalter (10) umfasst oder als eine Kombination aus einem Druckknopf und einem Drehrad und/oder einem Wippschalter (10) ausgebildet ist.

9. Tastkopf nach Anspruch 8,
**dadurch gekennzeichnet,**
**dass** das Bedienelement (7) über das angeschlossene Messgerät (9) programmierbar ist.

10. Tastkopf nach Anspruch 1,
**dadurch gekennzeichnet,**
**dass** die Schnittstelle (8), über die der Tastkopf (1) mit dem elektronischen Messgerät (9) verbunden ist, eine drahtlose Schnittstelle ist.

11. Tastkopf nach Anspruch 1,
**dadurch gekennzeichnet,**
**dass** die Schnittstelle (8), über die der Tastkopf (1) mit dem elektronischen Messgerät (9) verbunden ist, ein serieller Gerätebus oder eine zusätzliche Steuerleitung ist, wobei der serielle Gerätebus bzw. die zusätzliche Steuerleitung in einem Mess-Kabel (4) integriert sind.

## Geänderte Patentansprüche

### Geänderte Patentansprüche gemäss Regel 86(2) EPÜ.

**1.** Tastkopf (1) mit einer Tastkopfspitze (2), wobei der Tastkopf (1) über eine Schnittstelle (8) an ein elektronisches Messgerät (9) anschließbar ist und an der Tastkopfspitze (2) ein Drucksensor (6) vorhanden ist, der einen Anpressdruck auf die Tastkopfspitze (2) erfasst und bei einem Überschreiten eines festgelegten Anpressdrucks eine bestimmte Funktionalität des angeschlossenen Messgeräts (9) auslöst,
**dadurch gekennzeichnet,**
**dass** beim Aufsetzen der Tastkopfspitze (2) auf eine elektrische Leitung eine Messung an dem angeschlossenen Messgerät (9) aktiviert oder gestoppt wird, wenn der momentane Anpressdruck den festgelegten Anpressdruck überschreitet.

**2.** Tastkopf nach Anspruch 1,
**dadurch gekennzeichnet,**
**dass** ein Bedienelement (7) mit festgelegter Funktionalität an einem Griff (3) des Tastkopfes (1) angebracht ist.

**3.** Tastkopf nach Anspruch 2,
**dadurch gekennzeichnet,**
**dass** das Bedienelement (7) einen Leitfähigkeitssensor aufweist, der bei einem Überschreiten einer festgelegten Leitfähigkeit eine bestimmte Funktionalität im angeschlossenen Messgerät (9) aktiviert.

**4.** Tastkopf nach Anspruch 3,
**dadurch gekennzeichnet,**
**dass** der Leitfähigkeitssensor bei manuellem Berühren des Bedienelements die Leitfähigkeit eines Fingers der Bedienperson erfasst.

**5.** Tastkopf nach Anspruch 2,
**dadurch gekennzeichnet**,
das Bedienelement einen Wärmesensor aufweist, der bei einem Überschreiten einer festgelegten Temperatur eine Funktionalität im angeschlossenen Messgerät (9) aktiviert.

**6.** Tastkopf nach Anspruch 5,
**dadurch gekennzeichnet,**
**dass** der Wärmesensor bei manuellem Berühren des Bedienelements die Temperatur eines Fingers der Bedienperson erfasst.

**7.** Tastkopf nach einem der Ansprüche 1 bis 6,
**dadurch gekennzeichnet,**
**dass** ein Bedienelement (7) mit programmierbarer Funktionalität am Griff (3) des Tastkopfes (1) angebracht ist, wobei dieses Bedienelement (7) zumindest einen Druckknopf, ein Drehrad oder einen Wippschalter (10) umfasst oder als eine Kombination aus einem Druckknopf und einem Drehrad und/oder einem Wippschalter (10) ausgebildet ist.

**8.** Tastkopf nach Anspruch 7,
**dadurch gekennzeichnet,**
**dass** das Bedienelement (7) über das angeschlossene Messgerät (9) programmierbar ist.

**9.** Tastkopf nach Anspruch 1,
**dadurch gekennzeichnet,**
**dass** die Schnittstelle (8), über die der Tastkopf (1) mit dem elektronischen Messgerät (9) verbunden ist, eine drahtlose Schnittstelle ist.

**10.** Tastkopf nach Anspruch 1,
**dadurch gekennzeichnet,**
**dass** die Schnittstelle (8), über die der Tastkopf (1) mit dem elektronischen Messgerät (9) verbunden ist, ein serieller Gerätebus oder eine zusätzliche Steuerleitung ist, wobei der serielle Gerätebus bzw. die zusätzliche Steuerleitung in einem Mess-Kabel (4) integriert sind.
